# EUROPEAN PATENT SPECIFICATION

(11) **EP 2 407 101 B1**
(45) Date of publication and mention of the grant of the patent: **01.04.2015**
(21) Application number: 09841472.5
(22) Date of filing: 12.03.2009
(51) Int. Cl.: G01R 33/48, A61B 5/055, G01T 1/161, G01T 1/16, G01R 33/38

(54) **OPEN PET-MRI MACHINE**
OFFENES PET-MRT-GERÄT
MACHINE TEP-IRM OUVERT

(43) Date of publication of application: 18.01.2012
(73) Proprietor: National Institute of Radiological Sciences, Chiba-shi, Chiba 263-8555 (JP)
(72) Inventor: YAMAYA, Taiga, Chiba-shi Chiba 263-8555 (JP); MURAYAMA, Hideo, Chiba-shi Chiba 263-8555 (JP); OBATA, Takayuki, Chiba-shi Chiba 263-8555 (JP); AOKI, Ichio, Chiba-shi Chiba 263-8555 (JP)
(74) Representative: Twelmeier Mommer & Partner
(86) International application number: PCT/JP2009/054780
(87) International publication number: WO 2010/103644

(56) References cited:
- WO-A1-2008/129666
- JP-A- 9 211 130
- JP-A- 10 146 341
- JP-T- 2002 526 152
- KR-A- 20080 105 442
- US-A1- 2006 273 795
- US-B1- 6 591 127
- TAIGA YAMAYA ET AL: "An initial investigation of open PET geometries", NUCLEAR SCIENCE SYMPOSIUM CONFERENCE RECORD, 2007. NSS '07. IEEE, IEEE, PI, 1 October 2007 (2007-10-01), pages 3688-3690, XP031206407, ISBN: 978-1-4244-0922-8
- GREEN D ET AL: "Split cylindrical gradient coil for combined PET-MR system", INTERNATIONAL SOCIETY FOR MAGNETIC RESONANCE IN MEDICINE. SCIENTIFIC MEETING AND EXHIBITION. PROCEEDINGS, INTERNATIONAL SOCIETY FOR MAGNETIC RESONANCE IN MEDICINE, US, vol. 16, 3 May 2008 (2008-05-03), page 352, XP002579026, ISSN: 1524-6965
- CIPRIAN CATANA: 'Simultaneous Acquisition of Multislice PET and MR Images: Initial Results with a MR-Compatible PET Scanner' THE JOURNAL OF NUCLEAR MEDICINE vol. 47, no. 12, 2006, pages 1968 - 19761

## Description

### TECHNICAL FIELD

The present invention relates to a PET/MRI hybrid machine that combines a PET device with an MRI device, and more particularly to an open PET/MRI hybrid machine that can simultaneously measure and image the same open space accessible from outside by the PET device and the MRI device, thereby acquiring biological functional information and morphological information at the same time.

### BACKGROUND ART

PET is a method of administering a compound that is labeled with positron-emitting radionuclides and imaging the distribution of the compound in the body as a tomographic image. While X-ray CT or MRI based tomographic images provide morphological information, PET images are referred to as functional images which express biological functional information. For example, PET images are capable of highly sensitive tumor detection though not precise in position. To add accurate positional information to a PET image, it is needed to superpose an X-ray CT image or MRI image, which is precise in position but low in sensitivity and detection power, on the PET image. For efficient superposition and scanning, PET/CT devices have been prevalent that combine a PET device and an X-ray CT device.

Since X-ray CT is typically higher than PET in exposure level, hybrid machines with MRI, which is free from radiation exposure, have been under development. (See Ciprian Catana et al. "Simultaneous Acquisition of Multislice PET and MR Images: Initial Results with a MR-Compatible PET Scanner" The Journal of Nuclear Medicine, Vol. 47, No. 12, December 2006 pp 1968-1976.) D. Green et al. report an increased interest in developing hybrid PET-MR imaging systems in "Split cylindrical gradient coil for combined PET-MR system", Proceedings of the Society for Magnetic Resonance in Medicine, Vol. 16 (2008) page 352.

Using such a PET/MRI hybrid machine, functional information and morphological information can be integrated to obtain highly-sensitive and accurate positional information. MRI techniques for imaging some biological functions, typified by fMRI, have also been advancing, and such PET/MRI hybrid machines can even acquire a PET-based functional image and an MRI-based functional image simultaneously. In any case, however, the closed field of view imposes a lot of psychological stress on the subject as well as makes interventional treatment difficult.

Meanwhile, open MRI devices have been developed and released that acquire MRI images of an open space. (See Joshua Lilienstien et al. "In Vivo Sonography Through an Open MRI Breast Coil to Correlate Sonographic and MRI Findings" AJR: 184, March 2005 s49-52, Hiroshi Iseki et al. "Intelligent Operating Theater Using Intraoperative Open-MRI" Magnetic Resonance in Medical Sciences, Vol.4, No.3, p. 129-136, 2005, Junta Harada et al. "Initial Experience of Percutaneous Renal Cryosurgery under the Guidance of a Horizontal Open MRI System" Radiation Medicine, Vol. 19, No. 6, 291-296 p.p., 2001, DiMaio SP et al. "Robot-assisted needle placement in open MRI: system architecture, integration and validation" Comput Aided Surg. 2007 Jan; 12(1): 15-24, DiMaio SP et al. "Robot-assisted needle placement in open MRI: system architecture, integration and validation" Stud Health Technol Inform. 2006; 119: 126-31.)

Such open MRI devices are used to administer treatments under MRI guidance, making use of MRI's high spatial resolution and noninvasiveness. Conventionally, the only modality capable of imaging an open space in a tomographic device has been MRI, whereas the applicant has proposed in US 2010/0128956 A1 an open PET device that allows PET diagnosis even during treatment, see also Taiga Yamaya, Taku Inaniwa, Shinichi Minohara, Eiji Yoshida, Naoko Inadama, Fumihiko Nishikido, Kengo Shibuya, Chih Fung Lam and Hideo Murayama, "A proposal of an open PET geometry," Phy. Med. Biol., 53, pp. 757-773, 2008. According to the technology, two separate detector rings are arranged apart in the direction of the body axis, and radiations are detected from lines of coincidence between the rings. This allows imaging of the open space between the detection rings.

The PET device according to US 2010/0128956 A1, has had a problem that the PET device by itself is not capable of acquiring morphological information. PET/MRI hybrid machines according to the preamble of claim 1 are known from the aforementioned ISMRM conference article of D. Green et al. and US2006/0273795 A1.

### DISCLOSURE OF THE INVENTION

The present invention has been achieved in order to solve the foregoing conventional problems, and it is an object thereof to make it possible to simultaneously measure and image the same open space accessible from outside by PET and MRI, thereby acquiring functional information and morphological information at the same time.

The foregoing object of the present invention has been achieved by the provision of a PET/MRI hybrid machine having the features in claim 1. This machine combines a PET device with an MRI device, including: an open PET device that has a PET field of view at least part of which is an open space accessible from outside; and an open MRI device that has an MRI field of view at least part of which is an open space accessible from outside, the open space of the PET field of view and the open space of the MRI field of view being allowed to overlap each other at least in part.

Here, two composite rings are opposed to each other with an open space accessible from outside therebetween so that the PET field of view and the MRI field of view overlap each other in the open space, the two composite rings each including one of the detector rings of the open PET device arranged in one of the magnets (i.e., coils creating static magnetic field) of the open MRI device.

An MRI RF coil may be fixed to or movably arranged on a bed that is insertable into the composite rings, and the RF coil and/or the bed may be moved so that the RF coil enters the open space to allow the PET field of view and the MRI field of view to overlap each other.

The RF coil may be moved with respect to the bed and in a longitudinal direction of the bed so as to adjust the MRI field of view in position.

A working unit may be arranged in the open space.

The working unit may be retractably arranged in the open space.

The working unit may be any of an image acquisition unit, an irradiation device, and a general-purpose interventional treatment unit, or a combination thereof.

The general-purpose interventional treatment unit may include at least any one of an automatic puncture device, an electromagnetic cautery needle, and a laparoscope.

The same field of view may be simultaneously imaged in three or more modalities.

A PET and/or MRI image(s) may be acquired at least once both before and after operation of the working unit.

A marking of a target position identified by a PET image that is acquired before operation of the working unit may be put on a simultaneously-acquired MRI image, and the marking may be displayed on a PET and/or MRI image(s) acquired after the operation of the working unit.

According to the present invention, it becomes possible to simultaneously measure and image the same open space accessible from outside by the PET device and the MRI device, thereby acquiring functional information and morphological information at the same time. This can provide a highly useful open space.

For example, treatment and PET/MRI diagnosis can be combined to check the position by MRI, diagnose biological functions by PET, and administer a real-time interventional treatment at the same time. Aside from conventional radiation therapy, treatment methods that can be combined include an ultrasonic cautery needle, puncture, a puncture cautery needle, ultrasonic-based sonodynamic therapy (SDT), laser-based photodynamic therapy (PDT), thermotherapy, radiation triggering, and RF triggering.

Performing diagnosis on the head in a PET/MRI device with a long tunnel-like patient port imposes high psychological stress on the subject. According to the present invention, the simultaneous PET and MRI measurements of the open space can significantly reduce the stress on the subject.

Open-type devices provide doctors and operators easy access to the subject, allowing easy condition check. In particular, in the field of brain researches, responses to visual and other stimulations are sometimes inspected by PET or MRI. The presence of the open space facilitates experiments.

Moreover, the open space allows installation of a third diagnostic device and the like, whereby the same field of view can be simultaneously imaged in three or more modalities. Examples of the third diagnostic device include an ultrasonic device, a SPECT device, a fluorescent imager, an optical camera, and an optical CT device.

### BRIEF DESCRIPTION OF THE DRAWINGS

Fig. 1 is a block diagram showing the overall configuration of a first embodiment of the present invention, including a side view and a front view thereof;
Fig. 2 is a perspective view showing the configuration of essential parts of the first embodiment and modifications thereof;
Fig. 3 is a block diagram showing the overall configuration of a second embodiment of the present invention, including a side view and a front view thereof;
Fig. 4 includes a side view and a front view showing the configuration of essential parts of a third embodiment of the present invention;
Fig. 5 is a block diagram showing the configuration of essential parts of a fourth embodiment of the present invention, including a side view and a front view thereof;
Fig. 6 includes a side view and a front view showing the configuration of essential parts of a fifth embodiment of the present invention;
Fig. 7 is a block diagram showing the overall configuration of a sixth embodiment of the present invention, including a side view and a front view thereof;
Fig. 8 is a block diagram showing the configuration of a general-purpose interventional treatment unit according to the sixth embodiment;
Fig. 9 is a flowchart showing an example of a diagnosis/treatment procedure according to the present invention;
Fig. 10 is a flowchart showing another example of the diagnosis/treatment procedure according to the present invention; and
Fig. 11 is a flowchart showing a modification of the diagnosis/treatment procedure according to the present invention.

### BEST MODE FOR CARRYING OUT THE INVENTION

Hereinafter, embodiments of the present invention will be described in detail with reference to the drawings.

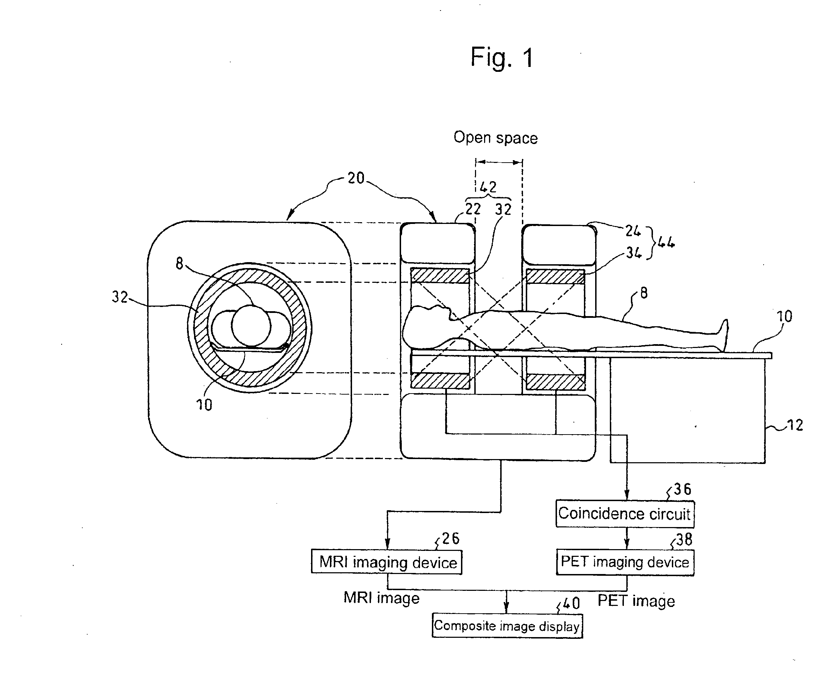

As shown in Fig. 1, a first embodiment of the present invention includes an open MRI device 20 of so-called doubled doughnut type, having two magnets 22 and 24 which are arranged apart in the direction of the body axis of a subject 8. Antimagnetic PET detector rings 32 and 34 are arranged in patient ports on respective sides to constitute composite rings 42 and 44. The space between the two separated, opposed composite rings 42 and 44 is the overlapping open space of MRI and PET. In the diagram, 12 represents a pedestal of a bed 10, 26 represents an MRI imaging device, 36 represents a coincidence circuit for PET measurement, 38 represents a PET imaging device, and 40 represents a composite image display which displays a morphological image obtained by the MRI imaging device 26 and a functional image obtained by the PET imaging device 38 in a superposed manner.

With such a configuration, radiations are measured from lines of coincidence between the PET detector rings 32 and 34, whereby the same open space as that of the MRI device can be imaged by PET. Working units such as an image acquisition unit, an irradiation device, and a general-purpose interventional treatment unit may be arranged in the open space. Coincidence measurement by the PET detector ring 32 itself and coincidence measurement by the PET detector ring 34 itself can be combined to acquire PET images over a wide field of view in the direction of the body axis, including the open space.

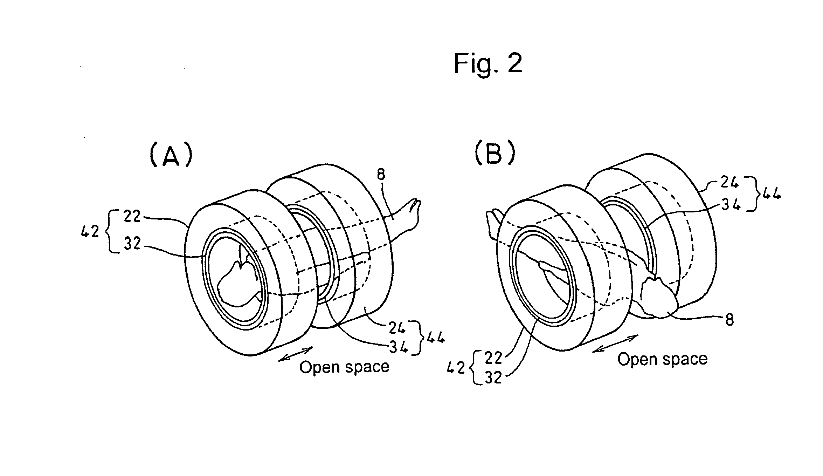

In Fig. 1, the composite rings 42 and 44 including the PET detector rings 32 and 34 arranged in the magnets 22 and 24, respectively, are arranged apart in the direction of the body axis of the subject 8 as shown in Fig. 2(A). However, the system configuration is not limited thereto. As shown in Fig. 2(B), the opposed composite rings 42 and 44 may be arranged apart in a direction orthogonal to the body axis of the subject.

According to the example of Fig. 2(A), the head of the subject is easily accessible.

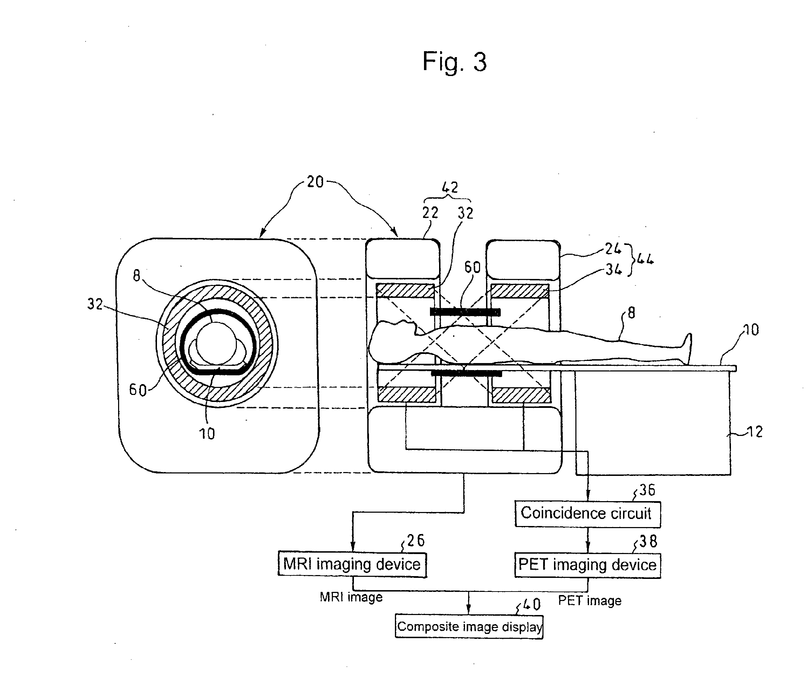

Next, a second embodiment of the present invention will be described in detail with reference to Fig. 3.

In the present embodiment, an RF coil 60 for MRI is fixed to or movably arranged on the bed 10. The RF coil 60 and/or the bed 10 is/are moved in the direction of the body axis of the subject 8 so that the RF coil 60 enters the open space to make the PET field of view and the MRI field of view overlap each other. The RF coil typically has a circular cylindrical frame structure to surround the affected area. The RF coil usually has a lot of openings and will not interfere with access to the affected area.

According to the present embodiment, the RF coil 60 and/or the bed 10 can be moved in the body axis of the subject 8 to adjust the field of view of the MRI image in position.

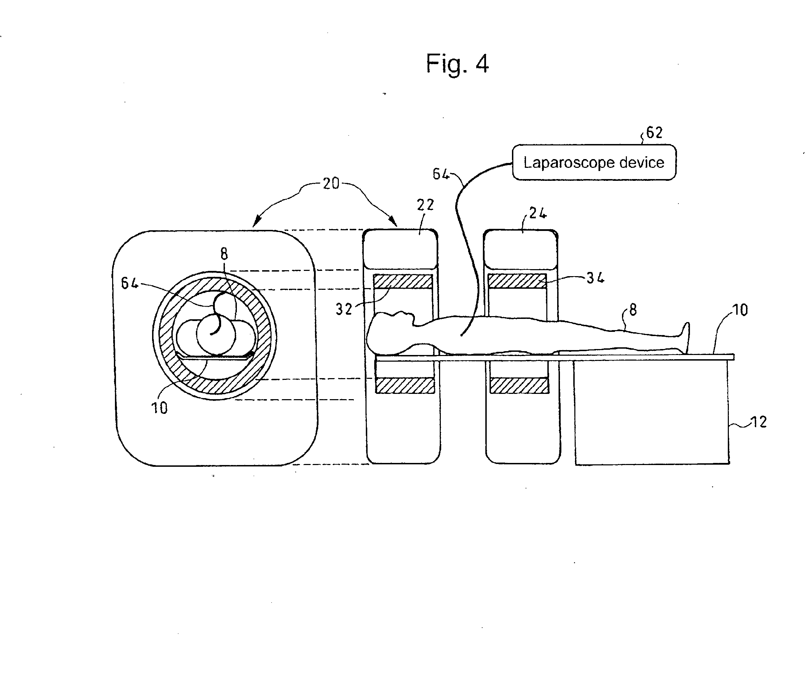

Fig. 4 shows an example where an inspection tube 64 of a laparoscope device 62 is inserted into the open space as a working unit and laparoscopic inspection/treatment is administered to the subject 8 according to the foregoing first embodiment.

Laparoscopic or endoscopic inspections and treatments refer to inspections and associated treatments using a laparoscope or angioscope, where a small cut is made in the skin or the like to insert the inspection tube 64, and inspections and associated treatments using an endoscope, where the inspection tube 64 is inserted through an aperture such as nasal and oral cavities. Aside from inspections and treatments that are manually performed by the inspector, inspections and associated treatments that are automatically or semiautomatically performed by mechanical means may also be included.

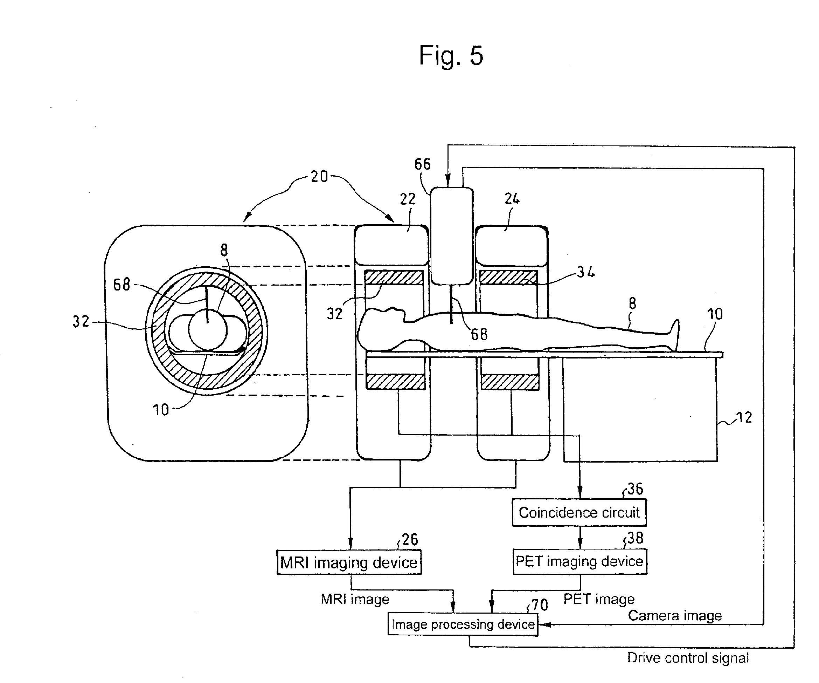

Fig. 5 shows an example where a needle 68 of an automatic puncture device 66 as a working unit is inserted into the subject 8 through the open space, similarly using the first embodiment.

Puncture inspections and treatments refer to inspections and associated treatments that involve inserting an inspection tube or treatment tool having the shape of a needle 68 through the skin or the like. Puncture inspections and treatments include biopsy, tumor cauterization, local administration of anti-tumor agents, and radio-wave therapy. Aside from inspections and treatments that are manually performed by the inspector, inspections and associated treatments that are automatically or semiautomatically performed by mechanical means may also be included.

In the example of Fig. 5, the automatic puncture device 66 is fixed to a position where the open spaces of both MRI and PET coincide with each other. The automatic puncture device 66 includes a not-shown digital video camera, lighting, a driver of the needle 68, a liquid medicine injection device, an electromagnetic heating device, and a tissue removal device (biopsy).

MRI images obtained by the MRI device 20, PET images obtained by the PET device (32 and 34), and pictures from the camera installed in the automatic puncture device 66 are transmitted to an image processing device 70, and the driver is controlled to insert the needle automatically and accurately into the intended area in the living body. Here, the three-dimensional position for the needle tip to reach is grasped and precisely controlled by using anatomical image information, angiographic image information, temperature image information, and water molecule diffusion image information from MRI, tumor position image information and malignancy image information from PET, skin surface insert position information and body tilt information from the digital video camera, etc.

Treatments with liquid medicines, electromagnetic radiation, and the like are administered from the tip of the needle 68 inserted in the subject 8 if needed. Or, necessary tissue may be removed. The treatment result or the treatment based on the removed tissue is imaged and processed by MRI and PET again, and further treatment is repeated if necessary.

It should be appreciated that the automatic puncture device 66 may be an automatic biopsy device, an automatic surgery device, and the like. Here, treatments by surgery refer to various surgical inspections and surgical treatments that involve cutting the skin or the like. Aside from inspections and treatments that are manually performed by the operator, inspections and associated treatments that are automatically or semiautomatically performed by mechanical means may also be included.

Such treatments are possible because both the PET and MRI are open.

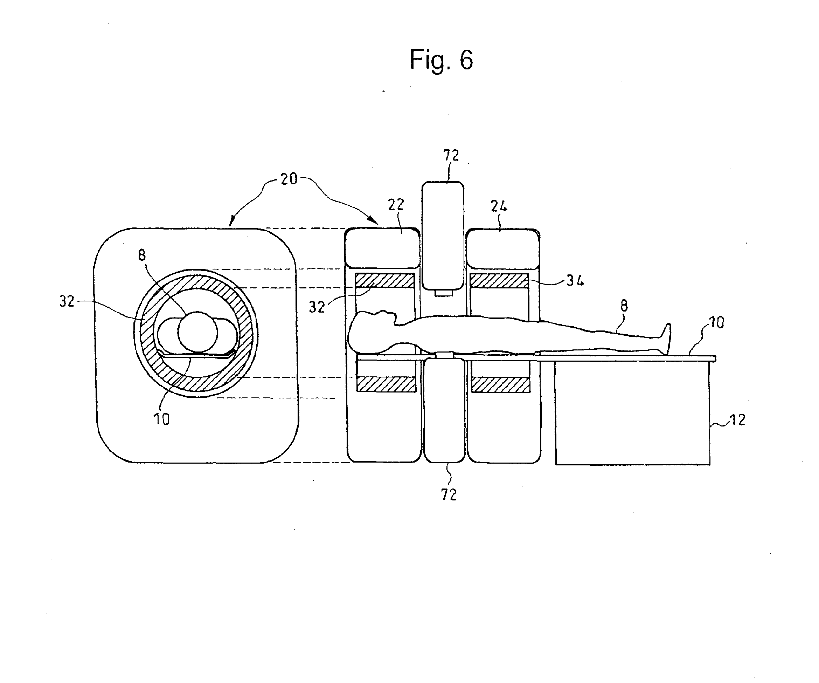

Fig. 6 shows an example where an image acquisition unit and an irradiation device 72 as working units are inserted into the open space to acquire various images or perform irradiation, using the foregoing first embodiment.

A plurality of conformation radiotherapy techniques involving radiation treatment on a selected tumor (such as heavy particle beam radiation therapy, proton beam radiation therapy, and IMRT) have been developed and receiving attention recently. Such techniques can intensively irradiate the affected area while suppressing damage to normal areas, whereas the irradiation field needs to be set accurately.

The open PET/MRI according to the present invention enables accurate checking of tumor margins by MRI when making a final treatment plan immediately before irradiation. Grasping low oxygen regions and active regions in the tumor by PET allows fine adjustments to the dose balance in the irradiated area. Conventionally, a treatment plan has been made by using CT or the like on a different day, in which case detailed information is not available and there is a risk of misalignment.

With the open PET/MRI, whether the actual irradiation field is set according to the treatment plan can be checked even during irradiation based on certain MRI measurements, PET ligands, and PET auto-radioactivation measurements. This allows quick irradiation assessment. Conventionally, it has been possible to predict radiation damage that appears a few months later.

Moreover, conformation radiotherapy often needs an irradiation angle as wide as 360°. The design of the open PET/MRI is right suited to such uses.

An image acquisition unit may be used to acquire images of the surface of the living body or inside the living body. The image acquisition unit may include visible light cameras and videos, optical measurements using visible light, infrared or near infrared cameras, X-ray CT, simple X-ray images, X-ray video cameras, fluorescent or luminescence imaging, optical coherence tomography, ultrasonic image probes, laser scanners, and MRI radio frequency coils.

Radiation or heat treatments refer to inspections and associated treatments that involve applying electromagnetic waves, sonic waves, ultrasonic waves, vibrations, heat, or the like from the surface of the skin or from a remote area. Inspections and treatments that involve irradiation with infrared rays, near infrared rays, visible light, X-rays, gamma rays, various types of particle beams, sonic waves, ultrasonic waves, vibrations, heat, and the like may be included. Medication and inspections to be triggered by such irradiations may also be included.

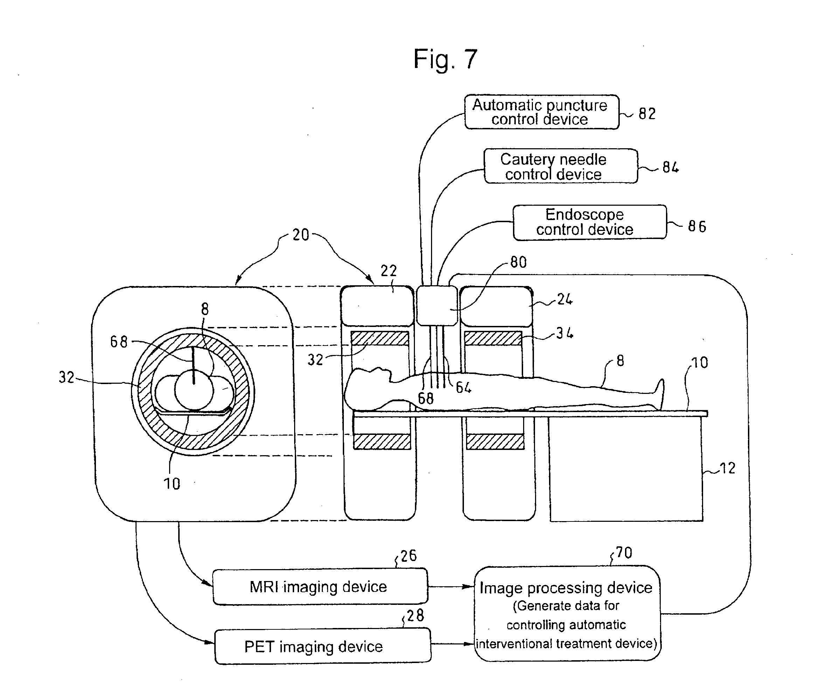

Fig. 7 shows an example where a general-purpose interventional treatment unit 80 as a working unit is arranged in the open space according to the first embodiment. The general-purpose interventional treatment unit 80 is connected with an automatic puncture control device 82 as well as a cautery needle control device 84, an endoscope control device 86, and the like. In the example, the image processing device 70 generates control data for the general-purpose interventional treatment unit 80 and performs feedback control on the inspection tube 64, the needle 68, etc.

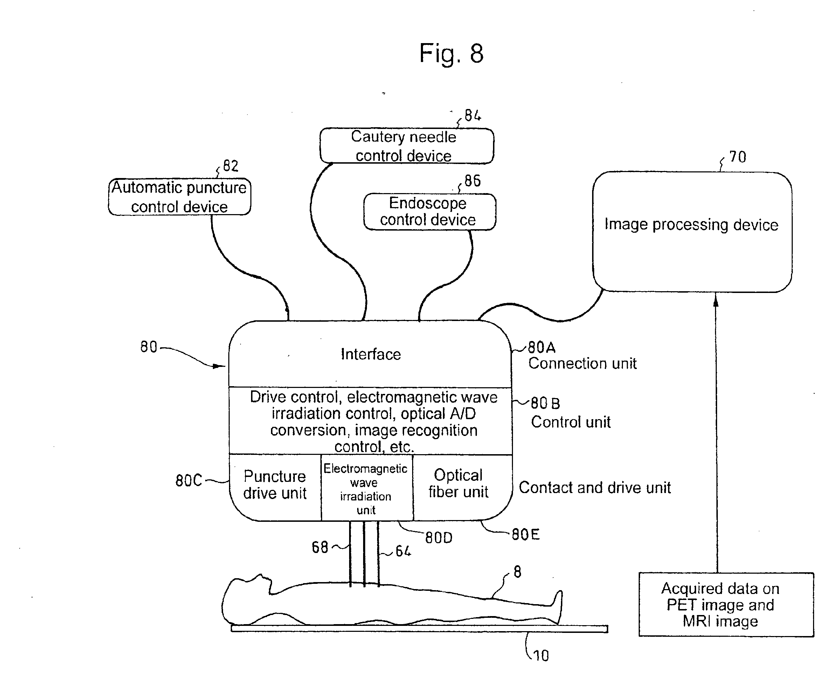

Fig. 8 is a block diagram showing the control of Fig. 7 in detail. The general-purpose interventional treatment unit 80 includes: a connection unit 80A which serves as an interface with the automatic puncture control device 82, the cautery needle control device 84, the endoscope control device 86, and the like; a control unit 80B which performs drive control, electromagnetic wave irradiation control, optical A/D conversion, image recognition control, and the like; and connection and drive units such as a puncture drive unit 80C, an electromagnetic wave irradiation unit 80D, and an optical fiber unit 80E.

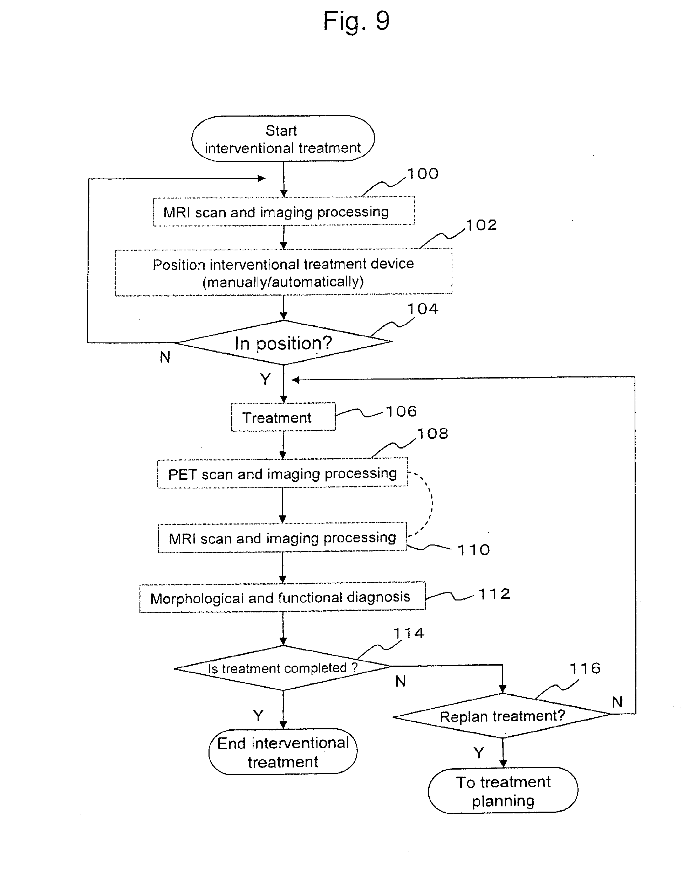

Fig. 9 is a flowchart showing the procedure in an example where positioning is performed by using MRI images (steps 100, 102, and 104). After treatment (step 106), PET and/or MRI diagnosis (step 108, 110, and 112) is performed and an instant evaluation is made on the treatment result (step 114).

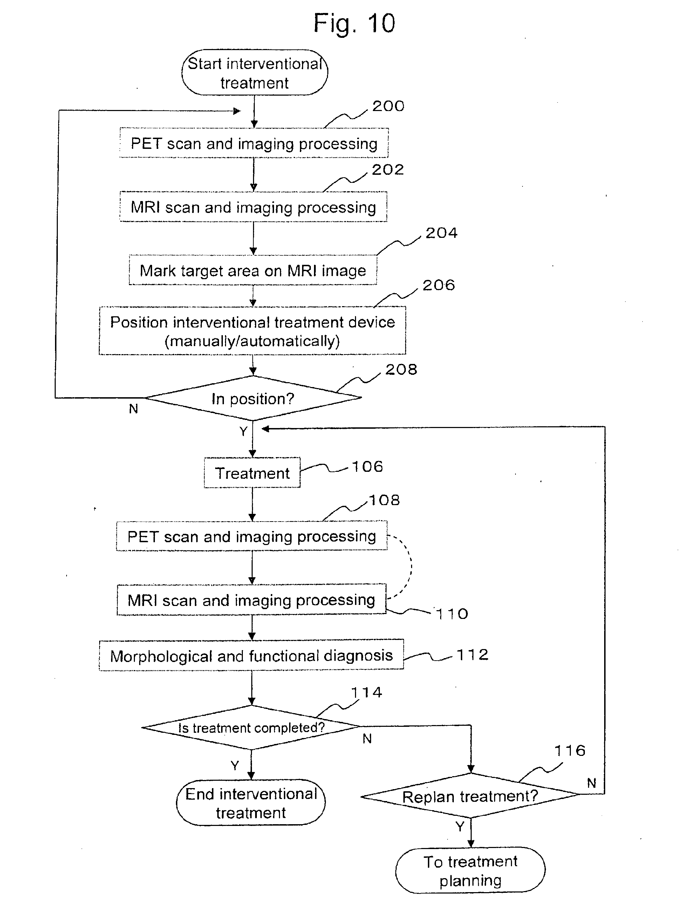

Fig. 10 is a flowchart showing one example of the procedure for situations where a cancer position is identified by FDG-PET before treatment, followed by cancer treatment. PET needs a time frame longer than that of MRI. In the example, a target position is identified by using a PET image (step 200), and its marking is put (step 204) on an MRI image that is simultaneously acquired (step 202). Under the MRI guidance, the interventional treatment device is positioned to the target (steps 206 and 208). After treatment (step 106), PET and/or MRI image diagnosis (steps 108, 110, and 112) is performed and an instant evaluation is made on the treatment result (step 114).

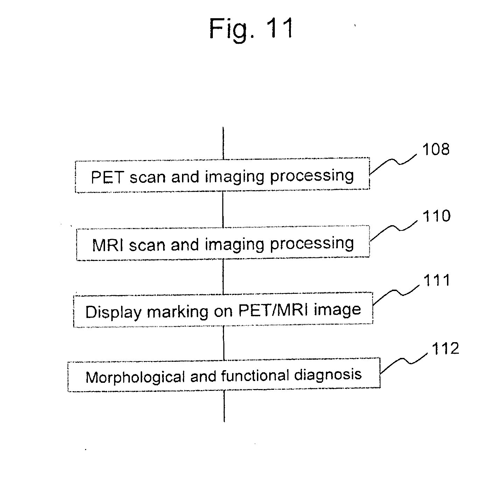

Fig. 11 is a flowchart where a step of displaying the marking put in step 204 on a PET and/or MRI image (step 111) is added to between the step of making PET and/or MRI image diagnosis (step 108 and 110) and the morphological and functional diagnosis step (step 112) of Fig. 10. This makes it possible to accurately check changes in the same area that is imaged at different times.

In any of Figs. 9 to 11, the PET scan and imaging processing (step 108, 200) and the MRI scan and imaging processing (step 110, 202) may be performed in reverse order. In Fig. 9, the MRI scan and imaging processing 110 may be omitted to make a diagnosis based only on the PET image in step 108. In Fig. 10, either one of the PET scan and imaging processing 108 and the MRI scan and imaging processing 110 may be omitted.

If in step 114 the treatment is determined not to be completed yet, then in step 116, determination is made as to whether treatment needs to be replanned. If not, the processing returns to step 106 to repeat the treatment according to the same treatment plan. If treatment needs to be replanned, a treatment plan is made again.

While the foregoing description has dealt with the cases where the number of PET detector rings is two, the number of PET detector rings may be three or more.

A television, computer, or other display for visualization, audio equipment, an odor generation device or tube, a skin irritating device, a taste stimulating device, and devices for acquiring and analyzing various types of biological information including pulses, blood pressure, an electrocardiogram, respiration, and blood components may be arranged in the open space for associated treatment.

Working units may be retractably arranged in the open space by using existing technologies. Such working units may be retracted when not needed in operation, whereby the open space is opened so as to be fully accessible from outside.

### INDUSTRIAL APPLICABILITY

The present invention is applicable to PET/MRI hybrid machines in general that combine a PET device and an MRI device, whereby functional information and morphological information can be simultaneously acquired from the same open space that is accessible from outside. This makes it possible to provide a highly useful open space suited to treatment and the like.

## Claims

1. A PET/MRI hybrid machine comprising:
a PET device;
a MRI device (20, 50) containing two coils (22, 44) for generating a static magnetic field of the MRI device (20, 50), and having a MRI field of view which is at least partly within an open space between said coils (22, 44);
**characterized in that**
the PET device comprises two detector rings (32, 34, 52, 54) which are opposed to each other, having a PET field of view in an open space between the two detector rings (32, 34, 52, 54);
each of said detector rings (32, 34, 52, 54) being arranged radially inside one of said two coils, so that two opposed composite rings (42, 44) are formed, with an open space therebetween, which is radially accessible from outside the PET/MRI hybrid machine, and in which the PET field of view and the MRI field of view overlap at least partly.

2. The PET/MRI hybrid machine according to claim 1,
containing a bed (10) that is insertable into the composite rings (42, 44), and an MRI RF coil (60) that is fixed to or movable arranged on the bed (10), and the RF coil is arranged within said open space.

3. The PET/MRI hybrid machine according to any of claims 1 to 2, wherein a working unit is arranged in the open space between the two composite rings (42, 44), the working unit being any of an image acquisition device, an irradiation unit, a general purpose interventional treatment unit, or a combination thereof.

4. The PET/MRI hybrid machine according to claim 3, wherein the working unit is retractably arranged in the open space between the two composite rings (42, 44) so that it can be retracted from said open space and the open space becomes fully accessible from the outside of the PET/MRI hybrid machine.

5. The PET/MRI hybrid machine according to claim 3, wherein the general-purpose interventional treatment unit includes at least any one of an automatic puncture device, an electromagnetic cautery needle, and a laparoscope.

6. The PET/MRI hybrid machine according to any of claims 3-5, wherein the working unit is an image acquisition unit selected from the group of visible light cameras and video cameras, infrared or near-infrared cameras, X-ray CT, X-ray cameras, X-ray video cameras, fluorescence or luminescence imaging devices, optical coherence tomography devices, ultrasonic image probes, laser scanners, and MRI radio frequency coils.

7. A method of using the PET/MRI hybrid machine according to any of claims 3 to 6, comprising the step of acquiring a PET and/or MRI image at least once before and after operation of the working unit.

8. A method of using the PET/MRI hybrid machine according to claim 7, further comprising the step of identifying a target position identified by a PET image acquired before operation of the working unit,
marking the target position on a simultaneously-acquired MRI image, and
displaying the marking on a PET and/or MRI image acquired after the operation of the working unit.

## Patentansprüche

1. Eine Hybridmaschine für die Positronen-Emissions-Tomographie/Magnetresonanz-Tomographie (PET/MRT), welche
eine PET-Einrichtung und
eine MRT-Einrichtung (20, 50) enthält, welche zwei Spulen (22, 44) zum Erzeugen eines statischen Magnetfeldes der MRT-Einrichtung (20, 50) enthält und ein MRT-Bildfeld hat, welches sich wenigstens teilweise in einem offenen Raum zwischen den beiden Spulen (22, 44) befindet,
**dadurch gekennzeichnet, dass**
die PET-Einrichtung zwei Detektorringe (32, 34, 52, 54) aufweist, welche einander gegenüber liegen und ein PET-Bildfeld in einem offenen Raum zwischen den beiden Detektorringen (32, 34, 52, 54) haben;
jeder der beiden Detektorringe (32, 34, 52, 54) ist radial innerhalb einer der beiden Spulen angeordnet, wodurch zwei einander gegenüber liegende zusammengesetzte Ringe (42, 44) gebildet sind, zwischen denen sich ein offener Raum befindet, welcher radial von außerhalb der PET/MRT Hybridmaschine zugänglich ist und in welchem sich das PET-Bildfeld und das MRT-Bildfeld wenigstens teilweise überlappen.

2. Die PET/MRT-Hybridmaschine nach Anspruch 1, welche ein in die zusammengesetzten Ringe (42, 44) einsetzbares Bett und eine MRT-Hochfrequenzspule (60) hat, die auf dem Bett (10) befestigt oder beweglich darauf angeordnet ist, wobei die Hochfrequenzspule in dem besagten offenen Raum angeordnet ist.

3. Die PET/MRT Hybridmaschine nach einem der Ansprüche 1 bis 2, in welcher in dem offenen Raum zwischen den beiden zusammengesetzten Ringen (42, 44) eine Arbeitseinheit angeordnet ist, welche ein Bilderfassungsgerät, eine Bestrahlungseinheit oder eine Mehrzweck-Behandlungseinheit für interventionelle Behandlungen oder eine Kombination davon sein kann.

4. Die PET/MRT-Hybridmaschine nach Anspruch 3, in welcher die Arbeitseinheit zurückziehbar in dem offenen Raum zwischen den beiden zusammengesetzten Ringen (42, 44) angeordnet ist, so dass sie aus dem offenen Raum zurückgezogen werden kann und der offene Raum vollständig von außerhalb der PET/MRT-Hybridmaschine zugänglich wird.

5. Die PET/MRT-Hybridmaschine nach Anspruch 3, in welcher die Mehrzweck-Behandlungseinheit für interventionelle Behandlungen wenigstens eines aus der folgenden Gruppe enthält: ein automatisches Punktiergerät, eine elektromagnetische Kauternadel und ein Laparoskop.

6. Die PET/MRT-Hybridmaschine nach einem der Ansprüche 3 bis 5, in welcher die Arbeitseinheit eine Bilderfassungseinheit ist, welche aus der Gruppe der mit sichtbarem Licht arbeitenden Kameras und Videokameras, der im Infrarot oder im nahen Infrarot arbeitenden Kameras, der Geräte für die Röntgen-Computertomographie, der Röntgenkameras, der Röntgen-Videokameras, der Geräte für die Fluoreszenz- oder Lumineszenz-Bildgebung, der Geräte für die optische Kohärenztomographie, der Ultraschallbildaufnehmer, der Laserscanner und der MRT-Hochfrequenzspulen ausgewählt ist.

7. Ein Verfahren zum Verwenden der PET/MRT-Hybridmaschine nach einem der Ansprüche 3 bis 6, in welchem wenigstens vor und nach der Betätigung der Arbeitseinheit ein PET-Bild und/oder ein MRT-Bild aufgenommen wird.

8. Ein Verfahren zum Verwenden der PET/MRT-Hybridmaschine nach Anspruch 7, in welchem außerdem eine Zielposition festgelegt wird, welche durch ein vor der Betätigung der Arbeitseinheit aufgenommenes PET-Bild ermittelt wurde, die Zielposition auf einem gleichzeitig aufgenommenen MRT-Bild markiert und die Markierung auf einem nach der Betätigung der Arbeitseinheit aufgenommenen PET-Bild und/oder MRT-Bild angezeigt wird.

## Revendications

1. Machine hybride TEP/IRM comprenant :
un dispositif TEP ;
un dispositif IRM (20, 50) contenant deux bobines (22, 44) permettant de générer un champ magnétique statique du dispositif IRM (20, 50), et ayant un champ de vue IRM qui se trouve au moins partiellement à l'intérieur d'un espace ouvert entre lesdites bobines (22, 44) ;
**caractérisée en ce que**
le dispositif TEP comprend deux bagues détectrices (32, 34, 52, 54) qui sont opposées l'une à l'autre, ayant un champ de vue TEP dans un espace ouvert entre les deux bagues détectrices (32, 34, 52, 54) ;
chacune desdites bagues détectrices (32, 34, 52, 54) étant agencée radialement à l'intérieur de l'une desdites deux bobines, de sorte que deux bagues composites opposées (42, 44) sont formées, avec un espace ouvert entre elles, qui est accessible radialement depuis l'extérieur de la machine hybride TEP/IRM, et dans lequel le champ de vue TEP et le champ de vue IRM se chevauchent au moins partiellement.

2. Machine hybride TEP/IRM selon la revendication 1,
contenant un lit (10) qui peut être inséré dans les bagues composites (42, 44), et une bobine RF IRM (60) qui est fixée au lit (10) ou est agencée de manière mobile dessus, et la bobine RF est agencée à l'intérieur dudit espace ouvert.

3. Machine hybride TEP/IRM selon l'une quelconque des revendications 1 à 2, dans laquelle une unité d'exploitation est agencée dans l'espace ouvert entre les deux bagues opposées (42, 44), l'unité d'exploitation étant l'un quelconque parmi un dispositif d'acquisition d'images, une unité d'irradiation, une unité de traitement interventionnel à objectif général ou une combinaison de ceux-ci.

4. Machine hybride TEP/IRM selon la revendication 3, dans laquelle l'unité d'exploitation est agencée de manière rétractable dans l'espace ouvert entre les deux bagues composites (42, 44) de sorte qu'elle peut être rétractée dudit espace ouvert et l'espace ouvert devient pleinement accessible depuis l'extérieur de la machine hybride TEP/IRM.

5. Machine hybride TEP/IRM selon la revendication 3, dans laquelle l'unité de traitement interventionnel à objectif général comprend au moins l'un quelconque parmi un dispositif de ponction automatique, une aiguille de cautérisation électromagnétique et un laparoscope.

6. Machine hybride TEP/IRM selon l'une quelconque des revendications 3-5, dans laquelle l'unité d'exploitation est une unité d'acquisition d'images sélectionnée dans le groupe des caméras à lumière visible et des caméras vidéo, des caméras infrarouges ou proche-infrarouges, d'une tomodensitométrie à rayons X, des caméras à rayons X, des caméras vidéo à rayons X, des dispositifs d'imagerie à fluorescence ou luminescence, des dispositifs de tomographie par cohérence optique, des sondes d'ultrasonographie, des scanners laser et des bobines radiofréquence IRM.

7. Procédé d'utilisation de la machine hybride TEP/IRM selon l'une quelconque des revendications 3 à 6, comprenant l'étape consistant à acquérir une image TEP et/ou IRM au moins une fois avant et après le fonctionnement de l'unité d'exploitation.

8. Procédé d'utilisation de la machine hybride TEP/IRM selon la revendication 7, comprenant en outre l'étape consistant à identifier une position cible identifiée par une image TEP acquise avant le fonctionnement de l'unité d'exploitation,
marquer la position cible sur une image IRM acquise simultanément, et
afficher le marquage sur une image TEP et/ou IRM acquise après le fonctionnement de l'unité d'exploitation.
